Europäisches Patentamt

European Patent Office

Office européen des brevets

(11) Publication number: **0 157 508 B1**

## EUROPEAN PATENT SPECIFICATION

(45) Date of publication of patent specification: **15.07.92**

(51) Int. Cl.5: **H01L 21/302**, C09J 4/00, C09J 7/00, H01L 21/312, H01L 21/68

(21) Application number: **85301674.9**

(22) Date of filing: **11.03.85**

The file contains technical information submitted after the application was filed and not included in this specification

(54) **Thin adhesive sheet for use in working semiconductor wafers.**

(30) Priority: **12.03.84 JP 47743/84**

(43) Date of publication of application:
**09.10.85 Bulletin 85/41**

(45) Publication of the grant of the patent:
**15.07.92 Bulletin 92/29**

(84) Designated Contracting States:
**DE FR GB IT**

(56) References cited:
**EP-A- 0 008 146**
**EP-A- 0 068 696**
**EP-A- 0 081 326**

**PATENT ABSTRACTS OF JAPAN vol. 5, no. 179 (E-82)(851),17 November 1981; & JP-A-56 107563**

(73) Proprietor: **NITTO DENKO CORPORATION**
**1-2, Shimohozumi 1-chome Ibaraki-shi Osaka(JP)**

(72) Inventor: **Uemura, Gosei Nitto Electric-Industrial Co. Ltd.**
**1-2, Shimohozumi 1-chome Ibaraki-shi Osaka(JP)**
Inventor: **Shigemura, Eiji Nitto Electric Industrial Co., Ltd**
**1-2, Shimohozumi 1-chome Ibaraki-shi Osaka(JP)**
Inventor: **Satoda, Yoshinari Nitto Elec. Ind. Co. Ltd.**
**1-2, Shimohozumi 1-chome Ibaraki-shi Osaka(JP)**

(74) Representative: **Dixon, Donald Cossar et al Gee & Co. Chancery House Chancery Lane London WC2A 1OU(GB)**

EP 0 157 508 B1

## Description

The present invention relates to a thin adhesive sheet for working semiconductor wafers. More particularly, it is concerned with a thin adhesive sheet which is used to protect the surface of a semiconductor wafer with IC elements formed thereon during the polishing step, or to fix the wafer when cutting and separating the semiconductor wafer into the IC element chips.

In the production of semiconductor wafers, the back of a semiconductor wafer with IC elements formed thereon is generally polished to make the wafer as thin and uniform as possible. For example, the thickness of the wafer is decreased from about 0.5 mm to about 0.2 to 0.3 mm by such polishing.

Various techniques have been employed to prevent breakage of the semiconductor wafer or damage of the wafer surface: (a) a method comprising coating a paint on the surface of the wafer to form a coating, polishing the back of the wafer and removing the coating with a solvent, (b) a method comprising laminating a thin sheet on the surface of the wafer as a spacer, polishing the back of the wafer and removing the sheet, and (c) a method comprising applying a pressure-sensitive thin adhesive sheet to the surface of the wafer, polishing the back of the wafer and peeling off the thin adhesive sheet.

In cutting and separating the semiconductor wafer into IC element chips, a method comprising forming wedge-shaped grooves of low depth on the surface of the semiconductor wafer in conformity with the shape of the desired IC chip and dividing the semiconductor wafer into the IC element chips by applying an external force, has been employed. This method, however, has disadvantages in that the separation accuracy is poor, and productivity is low since the IC element chips after cutting and separating must be transferred to the subsequent mounting step by hand.

For this reason, the direct pick-up method has now been employed, comprising fixing the semiconductor wafer by bonding thereto a thin adhesive sheet, cutting the assembly into the IC element chips by means of a rotary blade and picking up the IC element chips from the thin adhesive sheet while simultaneously mounting the chips.

In the above direct pick-up method, the semiconductor wafer is washed with water under a hydraulic pressure of at least 20 Pa (2 kg/cm$^2$) to remove friction heat and scraps during cutting the semiconductor wafer with the rotary blade. Thus, it is required for the thin adhesive sheet to have a sufficient adhesive force to withstand the hydraulic force. If, however, the adhesive force is too large, it is difficult for the IC element chips to be picked up from the thin adhesive sheet. For this reason, the adhesion force of the thin adhesive sheet is controlled so as to be capable of withstanding the above hydraulic pressure but not to lower the efficiency of the pick-up operation.

However, the adhesive force of the thin adhesive sheet can be controlled as described above only when the size of the final IC element chip is up to about 20 mm$^2$. In the case of IC element chips having a size of 50 mm$^2$ or more as a recent LSI having an increased degree of accumulation, it is difficult for the thin adhesive sheet to control the adhesive force as described above, and the above-described direct pick-up method cannot be applied.

Various investigations have been made to provide a thin adhesive sheet which can be used even when the size of the IC element chip is 50 mm$^2$ or more.

Accordingly, an object of the present invention is to provide a thin adhesive sheet for working semiconductor wafers, comprising a light-permeable support and provided thereon a pressure-sensitive adhesive layer which can be cured by light irradiation, thereby forming a three-dimensional network structure.

According to the present invention we provide a thin adhesive sheet for use in working semiconductor wafers, comprising a light-permeable support and provided thereon a pressure-sensitive adhesive layer which can be cured by irradiation with light to form a three-dimensional network structure, wherein the pressure-sensitive adhesive layer is a composition comprising 100 parts by weight of a rubber or acrylic polymer, from 1 to 100 parts by weight of a photopolymerizable compound having a number average molecular weight of 10,000 or less and containing at least two photopolymerizable carbon-carbon double bonds in the molecule, and from 0.1 to 5 parts by weight of a photopolymerization initiator, and the 180° peeling adhesive force of the pressure-sensitive adhesive layer to a semi conductor wafer (as determined at a peeling speed of 300 mm/min) on a unit width of 20 mm is 2 N (200 g/20 mm) or more and, after irradiation with light decreases to 1.5 N (150 g/20 mm) or less.

The adhesive force of the thin adhesive sheet can be increased to a sufficiently high level without paying any specific attention to the efficiency of the pick-up operation after the wafer cutting process for the reason as described hereinafter. As a result, during the wafer cutting process, IC element chips are firmly bonded to the thin adhesive sheet and, even if subjected to the pressure of washing water, the chips never drop off the adhesive sheet.

After the wafer cutting process, the pressure-sensitive adhesive layer is cured by irradiating with light from the support side of the thin adhesive sheet, thereby forming a three-dimensional network structure. By the formation of the three-dimensional network structure, the cohesive force of the adhesive layer increases and the adhesiveness thereof is substantially lost. As a result, the adhesive force of the thin adhesive sheet to the IC element chips is remarkably reduced. Consequently, the pick-up operation can be carried out easily and irrespective of the size of the IC element chip, viz., even if the size of the IC element chip is more than 50 mm$^2$.

When the thin adhesive sheet of the present invention is used, the direct pick-up system can be applied even if the size of the IC element chip exceeds 50 mm$^2$ and productivity does not decrease.

Examples of light-permeable supports which can be used in preparing the thin adhesive sheet of the present invention include films of synthetic resins such as polyvinyl chloride, polyethylene terephthalate, polyethylene, and polypropylene. These films may be heat-shrinkable films. In addition, stretchable films made of polyolefins having rubber elasticity, such as polybutene and 1,2-polybutadiene, can also be used. The thickness of the film is generally from 10 to 300 $\mu$m.

The pressure-sensitive adhesive layer which can be cured by light irradiation to form a three-dimensional network structure is prepared using a pressure-sensitive adhesive composition comprising a mixture of a rubber- or acryl-based pressure-sensitive adhesive, a low molecular weight compound having at least two photopolymerizable carbon-carbon double bonds in the molecule (hereinafter referred to as a "photopolymerizable compound") and a photopolymerization initiator.

The above rubber- or acryl-based pressure-sensitive adhesive is composed of, as a base polymer, rubbers such as natural rubber and various synthetic rubbers, or acryl-based polymers such as polyalkyl acrylate or methacrylate or copolymers comprising from about 50 to 99.5% by weight of alkyl (meth)-acrylate and from about 50 to 0.5% by weight of an unsaturated monomer copolymerizable therewith, and, if necessary, a cross-linking agent such as polyisocyanates or alkyletherized melamine compounds, in an amount of from 0.1 to 10 parts by weight per 100 parts by weight of the base polymer. The above base polymers, i.e., rubbers or acryl polymers, may have photopolymerizable carbon-carbon double bonds in the molecule.

The photopolymerizable compound has a number average molecular weight of about 10,000 or less. In order that the pressure-sensitive adhesive layer may form a three-dimensional network structure with high efficiency by light irradiation, it is more preferred for the compound to have the molecular weight of about 5,000 or less and the number of photopolymerizable carbon-carbon double bonds in the molecule of from 2 to 6, particularly from 3 to 6. Particularly preferred examples of these photopolymerizable compounds are trimethylolpropane triacrylate, pentaerythritol triacrylate, pentaerythritol tetraacrylate, dipentaerythritol monohydroxypentaacrylate, and dipentaerythritol hexaacrylate. Other photopolymerizable compounds which can be used include 1,4-butanediol diacrylate, 1,6-hexanediol diacrylate, polyethylene glycol diacrylate, and commercially available oligoester acrylate.

These photopolymerizable compounds can be used alone or as mixtures thereof. The amount of the photopolymerizable compound used is in the range of from 1 to 100 parts by weight per 100 parts by weight of the base polymer. If the amount of the photopolymerizable compound used is too small, the three-dimensional network structure is formed only insufficiently by the light irradiation of the pressure-sensitive adhesive layer and reduction in the adhesion force of the thin adhesive sheet to the IC element chip is too small. On the other hand, if the amount thereof is too large, the plasticity of the resulting pressure-sensitive adhesive layer markedly increases and the necessary adhesive force cannot be obtained in the wafer cutting process.

Examples of the photopolymerization initiators which can be used include isopropyl benzoin ether, isobutyl benzoin ether, benzophenone, Michler's ketone, chlorothioxanthone, dodecylthioxanthone, dimethylthioxanthone, diethylthioxanthone, acetophenone diethylketal, benzyl dimethylketal, $\alpha$-hydroxycyclohexyl phenyl ketone, and 2-hydroxymethylphenylpropane. These compounds can be used alone or as mixtures thereof.

The amount of the photopolymerization initiator used is in the range of from 0.1 to 5 parts by weight per 100 parts by weight of the base polymer. If the amount of the photopolymerization initiator used is too small, the three-dimensional network structure is formed only insufficiently by the irradiation of the pressure-sensitive adhesive layer with light, and reduction in the adhesive force of the thin adhesive sheet to the IC element chip is too small. On the other hand, even if the amount thereof is increased, any further effect cannot be obtained. Rather, the photopolymerization initiator undesirably remains on the surface of the IC element chip. If necessary, amine compounds such as triethylamine, tetraethylpentamine, and dimethylaminoethanol may be used as photopolymerization accelerators in combination with the above-described photopolymerization initiators.

The pressure-sensitive adhesive composition composed of the above-described components is coated on the light-permeable support and then, if necessary, heated to thereby form the pressure-sensitive adhesive layer. The thickness of the pressure-sensitive adhesive layer is generally in the range of from about 5 to 70 $\mu$m in dry thickness.

The 100% modulus (20°C) of the pressure-sensitive adhesive layer is generally 10 kg/cm$^2$ or less, and preferably from 0.5 to 8 kg/cm$^2$. The gel content therein as determined by immersing in toluene (at 20°C) for 24 hours is usually less than 55% by weight, preferably from 0.5 to less than 55% by weight, and more preferably from 35 to less than 55% by weight, and the degree of swelling of the gel is generally at least 20 times and preferably from 25 to 80 times.

In cutting and separating the semiconductor wafer into element chips by using the thin adhesive sheet of the present invention, comprising the above-described light-permeable support and pressure-sensitive adhesive layer, the semiconductor wafer is first adhered and fixed to the thin adhesive sheet, and the semiconductor wafer is then subjected to semifull or full cutting using a cutting blade such as a rotary blade. The thin adhesive sheet is irradiated with light having a wavelength range of from 180 to 460 nm from the support side thereof for 2 to 180 seconds using e.g. a high pressure mercury lamp or a super pressure mercury lamp. The element chips are then picked up and simultaneously mounted in the procedure, for example, such that the element chip is adsorbed with an air pinset simultaneously with application of a physical means such as pushing up with a needle.

In the case that the heat-shrinkable synthetic resin film is used as the support of the thin adhesive sheet, the sheet can be applied under tension by heating the heat-shrinkable synthetic resin film prior to or after fixation of the semiconductor wafer, so that the thin adhesive sheet does not deform during the wafer cutting process, and the semiconductor wafer can be cut accurately. In the case that the stretchable synthetic resin or rubber film is used as the support of the adhesive sheet, if the sheet after the cutting process is uniformly stretched, fixed, and then irradiated with light in that state, a proper gap is maintained between chips and, as a result, the air pinset is prevented from coming into contact with the neighboring chip and thereby scratching the chip during the pick-up operation.

In these procedures, irradiation with light may be applied on the entire surface of the thin adhesive sheet, or only on an area where the semiconductor wafer is bonded to the thin adhesive sheet. In addition, a method comprising irradiating element chips with light one by one successively and then picking up every chip may be employed.

In polishing the back of the semiconductor wafer using the thin adhesive sheet, the thin adhesive sheet of the present invention is applied to the front surface of the semiconductor wafer and the back is polished. Thereafter before peeling the thin adhesive sheet, the pressure-sensitive adhesive layer is cured by irradiating with light from the support side, thereby forming the three-dimensional network structure. Due to the formation of this three-dimensional network structure, the cohesive force of the adhesive layer increases and the adhesiveness thereof diminishes substantially, resulting in a marked reduction in adhesive force of the thin adhesive sheet to the semiconductor wafer. Therefore, regardless of the surface condition of the semiconductor wafer, the thin adhesive sheet can then be peeled off easily.

The 180° peeling adhesion force (peeling speed: 300 mm/min) on a unit width of 20 mm of the thin adhesive sheet to the semiconductor wafer prior to irradiation with light is at least 2N (200 g/20 mm), preferably from 2 to 17.7N (200 to 1,800 g) and more preferably 2 to 9.8N (200 to 1,000 g/20 mm). Thus, even under a hydraulic pressure of about 20 Pa (2 kg/cm$^2$) which is generally applied during the wafer cutting process, the element chips never drop off from the thin adhesive sheet.

When the pressure-sensitive adhesive layer is irradiated with light, the photopolymerizable compound is polymerized and, at the same time, free radicals are generated in the base polymer, and the thus-excited base polymer reacts with the photopolymerizable compound. As a result, the pressure-sensitive adhesive layer is cured, thereby forming the three-dimensional network structure.

The term "three-dimensional network structure" as used herein means that the gel content as determined by immersing the pressure-sensitive adhesive layer in toluene (20°C) for 24 hours is at least about 1.05 times, preferably at least about 1.2 times, and more preferably at least about 1.4 times the gel content before irradiation with light, and is at least 55% by weight, preferably at least 60% by weight, and more preferably at least 70% by weight. The pressure-sensitive adhesive layer irradiated with light has generally the degree of swelling of gel determined above of 18 times or less, and preferably from 5 to 15 times.

Due to the formation of the three-dimensional network structure, the cohesive force of the pressure-sensitive adhesive layer is markedly increased as compared with that prior to irradiation with light. The 100% modulus (20°C) is generally increased to at least 20 kg/cm$^2$, preferably from 25 to 150 kg/cm$^2$, and more preferably from 28 to 100 kg/cm$^2$. As a result, the adhesiveness of the pressure-sensitive adhesive

4

layer is substantially lost and the adhesive force of the thin adhesive sheet to element chips markedly decreases. At this time, the 180° peeling adhesion force (peeling speed: 300 mm/min) per 20 mm width is 1.47N (150 g/20 mm) or less and preferably from 0.05 to 1.23N (5 to 125 g/20 mm). Therefore, even if the size of the element chip is more than 50 mm$^2$, the element chips can be easily picked up from the thin adhesive sheet.

The present invention is described in greater detail by reference to the following non-limiting Examples. All parts are by weight, in the Examples.

### EXAMPLE 1

A composition of 100 parts of butyl acrylate, 5 parts of acrylonitrile, and 5 parts of acrylic acid, was copolymerized in toluene to obtain an acrylic copolymer having a number average molecular weight of 300,000.

To 100 parts of the acrylic copolymer were added 5 parts of a polyisocyanate compound (trade name: "Coronate L", produced by Nippon Polyurethane Co., Ltd.), 15 parts of dipentaerythritol monohydroxypentaacrylate, and 1 part of α-hydroxycyclohexyl phenyl ketone, and they were mixed to prepare a pressure-sensitive adhesive composition.

This composition was coated on one surface of a 50 μm thick polyethylene terephthalate film in a thickness of 10 μm, and then dried at 130°C for 3 minutes, to obtain a thin adhesive sheet for working semiconductor wafers.

### EXAMPLE 2

To 100 parts of the same acrylic copolymer as prepared in Example 1 were added 5 parts of the same polyisocyanate compound as used in Example 1, 20 parts of pentaerythritol triacrylate, and 0.5 part of isobutyl benzoin ether, and they were mixed to prepare a pressure-sensitive adhesive composition. This composition was processed in the same manner as in Example 1 to obtain a thin adhesive sheet.

### EXAMPLE 3

To 100 parts of the same acrylic copolymer as prepared in Example 1 were added 5 parts of the polyisocyanate compound as used in Example 1, 10 parts of dipentaerythritol monohydroxypentaacrylate, 1 part of dimethylthioxanthone, and 1 part of triethylamine, and they were mixed to prepare a pressure-sensitive adhesive composition. This composition was processed in the same manner as in Example 1 to obtain a thin adhesive sheet.

### EXAMPLE 4

A composition of 100 parts of butyl acrylate and 7.5 parts of acrylic acid was copolymerized in toluene to prepare an acrylic copolymer having a number average molecular weight of 300,000. Thereafter, the same method as in Example 1 was followed except that the above-prepared acrylic copolymer was used as the copolymer, to obtain a thin adhesive sheet.

### EXAMPLE 5

A thin adhesive sheet was obtained in the same manner as in Example 1 except that 40 parts of 1,6-hexanediol diacrylate was used in place of 15 parts of dipentaerythritol monohydroxypentaacrylate.

### EXAMPLE 6

A thin adhesive sheet was obtained in the same manner as in Example 1 except that 50 parts of a polyfunctional oligoester acrylate (trade name, "Aronix M-8030", produced by Toa Gosei Kagaku Kogyo K.K.) was used in place of 15 parts of dipentaerythritol monohydroxy pentaacrylate.

### COMPARATIVE EXAMPLE

For the sake of comparison, a thin adhesive sheet was obtained in the same manner as in Example 1 except that 15 parts of dipentaerythritol monohydroxy pentaacrylate and 1 part of α-hydroxycyclohexyl phenyl ketone were not used.

TEST EXAMPLE 1

A semiconductor wafer having a diameter of 12.7 cm (5 inches) was bonded to each thin adhesive sheet obtained in Examples 1 to 6 and the Comparative Example, and the assembly was then cut into element chips having a size of 50 mm$^2$ using a rotary blade. This wafer cutting process was carried out while washing with water under a hydraulic pressure of 20 Pa (2 kg/cm$^2$). In all the thin adhesive sheets, not one element chip dropped.

After the wafer cutting process, the thin adhesive sheet was irradiated with light from the support side thereof for 20 seconds using a high pressure mercury lamp (40 W/cm) placed at a distance of 15 cm. Element chips were picked up by pushing up using a needle while simultaneously adsorbing with an air pinset.

In the thin adhesive sheets obtained in Examples 1 to 6, the element chips could be easily picked up and, furthermore, the pressure-sensitive adhesive layer was not transferred at all to the element chips. On the other hand, in the case of the thin adhesive sheet obtained in the Comparative Example, the element chips remained bonded firmly to the thin adhesive sheet and could not be picked up.

TEST EXAMPLE 2

180° Peeling Adhesion Force:

The thin adhesive sheets obtained in Examples 1 to 6 and the Comparative Example were measured for the 180° peeling adhesion force (peeling speed: 300 mm/min) to the semiconductor wafter. Similarly, after the thin adhesive sheet was bonded to the semiconductor wafer and irradiated with light from the support side thereof under the same conditions as in Test Example 1, the adhesion force was measured.

100% Modulus :

Seven samples of a 50 $\mu$m thick polyethylene terephthalate film were each coated with a respective pressure-sensitive adhesive composition in a thickness of 10 $\mu$m, heated at 130°C for 3 minutes, cut into pieces having a size of 50 mm x 50 mm, and collected into a bar-like form to prepare a yarn-like test piece having a cross-sectional area of 0.5 mm$^2$. The test piece was measured for 100% modulus at 20°C. Further, other coated samples were cut to a size of 50 mm x 50 mm and irradiated with light under the same conditions as in Test Example 1; each test piece thus treated was collected into a bar-like form in the same manner as above, and its 100% modulus was measured.

Gel Content and Degree of Swelling of Gel:

After coating and heating each pressure-sensitive adhesive composition in the same manner as in the preparation of the test piece for the measurement of the 100% modulus, a test piece having a size of 50 mm x 500 mm was cut out. This test piece was immersed in toluene (at 20°C) for 24 hours to measure the gel content and the degree of swelling of gel. Further, another piece cut into a size of 50 mm x 500 mm was irradiated with light under the same conditions as in Test Example 1. The test piece thus treated was immersed in toluene for 24 hours to measure the gel content and the degree of swelling of gel.

The results obtained are shown in the Table below. In the Table, the measurement values prior to irradiation with light are shown in column A, and the measurement values after irradiation with light, in Column B.

6

TABLE

| Run No. | 180° Peeling Adhesion Force N (g/20 mm) | | 100% Modulus (kg/cm²) | | Gel Fraction (wt%) | | Degree of Swelling of Gel (times) | |
|---|---|---|---|---|---|---|---|---|
| | A | B | A | B | A | B | A | B |
| Example 1 | 4.9 (500) | 0.29(30) | 2.0 | 60 | 50 | 85 | 25 | 10 |
| Example 2 | 5.2 (530) | 0.67(70) | 3.0 | 80 | 50 | 85 | 28 | 12 |
| Example 3 | 2.9 (300) | 0.25(25) | 4.0 | 85 | 50 | 80 | 26 | 8 |
| Example 4 | 7.8 (800) | 0.34(35) | 0.5 | 30 | 40 | 70 | 20 | 10 |
| Example 5 | 3.3 (340) | 0.99(100) | 1.5 | 50 | 40 | 65 | 30 | 13 |
| Example 6 | 3.1 (320) | 1.2(120) | 2.0 | 55 | 40 | 65 | 35 | 15 |
| Comparative Example | 3.4 (350) | 7.8(800) | 2.0 | 3.0 | 52 | 55 | 23 | 20 |

EXAMPLE 7

A thin adhesive sheet obtained as in Example 1, except that the thickness of the adhesive layer was 30 μm, was bonded to the surface of a semiconductor wafer having a diameter of 12.7 cm (5 inches) and a thickness of 0.5 mm with IC elements formed on the surface thereof. The surface of the wafer was polished, using a surface grinder. In this polishing, the semiconductor wafer was neither broken nor cracked, and the surface of the semiconductor wafer was not scratched. Moreover, permeation of water between the semiconductor wafer and the adhesive sheet did not occur.

After the polishing process, the adhesive sheet was irradiated with light for 20 seconds, from the polyethylene terephthalate film side, using a high pressure mercury lamp (40 W/cm) placed at a distance of 15 cm, and then peeled off from the semiconductor wafer. This peeling could be performed very easily, and the transfer of the pressure-sensitive adhesive layer to the surface of the semiconductor wafer was not observed at all. The thus-polished semiconductor wafer had a thickness of 0.25 cm and an entire uniform thickness. The 180° peeling adhesive force of the adhesive sheet of unit width of 20 mm was 3.4N (350 g/20 mm) prior to irradiation with light, and 0.34N (35 g/20 mm) after irradiation with light.

It can be seen from the above results that when the thin adhesive sheet of the present invention is used in working the semiconductor wafer, element chips obtained by cutting the semiconductor wafer are firmly bonded to the thin adhesive sheet and never drop from the thin adhesive sheet during the wafer cutting process, and, after the wafer cutting process, the element chips can be easily picked up by irradiation of the thin adhesive sheet with light from the support side, even though the size of the element chip is more than 50 mm$^2$. Furthermore, in the polishing step, the semiconductor wafer can be polished efficiently and the thin adhesive sheet can be easily peeled off.

The reason why the element chips can be easily picked up and after polishing, and the thin adhesive sheet can be easily peeled off, can be understood from the fact that the cohesive force of the pressure-sensitive adhesive layer markedly increases due to the formation of the three-dimensional network structure by irradiation of the thin adhesive sheet with light and, as a result, the adhesive force of the thin adhesive sheet to the element chips markedly decreases.

**Claims**

1. A thin adhesive sheet for use in the working of semiconductor wafers, comprising a light-permeable support and provided thereon a pressure-sensitive adhesive layer which can be cured by irradiation with light to form a three-dimensional network structure, wherein the pressure-sensitive adhesive layer is a composition comprising 100 parts by weight of a rubber or acrylic polymer, from 1 to 100 parts by weight of a photopolymerizable compound having a number average molecular weight of 10,000 or less and containing at least two photopolymerizable carbon-carbon double bonds in the molecule, and from 0.1 to 5 parts by weight of a photopolymerization initiator, and the 180° peeling adhesive force of the pressure-sensitive adhesive layer to a semiconductor wafer (as determined at a peeling speed of 300 mm/min) on a unit width of 20 mm is 2 N (200 g/20 mm) or more and, after irradiation with light, decreases to 1.5 N (150 g/20 mm) or less.

2. An adhesive sheet as claimed in Claim 1, wherein the light-permeable support is a heat-shrinkable plastic film or a stretchable synthetic resin or rubber film.

3. An adhesive sheet as claimed in Claim 2, wherein the support is a film of polyvinyl chloride, polyethylene terephthalate, polyethylene or polypropylene.

4. An adhesive sheet as claimed in any preceding claim, wherein the light-permeable support has a thickness of from 10 to 300 $\mu$m.

5. An adhesive sheet as claimed in any preceding claim, wherein the acrylic polymer is an alkyl (meth)-acrylate or a copolymer comprising by weight 50 to 99.5% of an alkyl (meth)acrylate and 50 to 0.5% of an unsaturated monomer copolymerizable therewith.

6. An adhesive sheet as claimed in any preceding claim, wherein the photopolymerizable compound has a number average molecular weight of 5,000 or less.

7. An adhesive sheet as claimed in any preceding claim, wherein the photopolymerizable compound has 3 to 6 photopolymerizable carbon-carbon double bonds in its molecule.

8. An adhesive sheet as claimed in any preceding claim, wherein the photopolymerizable compound is selected from trimethylolpropane triacrylate, pentaerythritol triacrylate, pentaerythritol tetraacrylate, dipentaerythritol monohydroxypentaacrylate and dipentaerythritol hexaacrylate.

**9.** An adhesive sheet as claimed in any preceding claim, wherein the photopolymerization initiator is selected from isopropyl benzoin ether, isobutyl benzoin ether, benzophenone, Michler's ketone, chlorothioxanthone, dodecylthioxanthone, dimethylthioxanthone, diethylthioxanthone, acetophenone diethylketal, benzyl dimethylketal, $\alpha$-hydroxycyclohexyl phenyl ketone and 2-hydroxymethylphenylpropane.

**10.** An adhesive sheet as claimed in any preceding claim, wherein the pressure-sensitive adhesive layer has a thickness of from 5 to 70 $\mu$m.

**11.** An adhesive sheet as claimed in any preceding claim, wherein the pressure-sensitive adhesive layer has a strength after 100% modulus at 20°C of 10 kg/cm$^2$ or less, a gel content (as determined by immersing in toluene at 20°C for 24 hours) of less than 55% by weight, and a degree of swelling of the gel of at least 20 times.

**12.** An adhesive sheet as claimed in Claim 11, wherein the 100% modulus is 0.5 to 8 kg/cm$^2$.

**13.** An adhesive sheet as claimed in Claim 11 or 12, wherein the gel content is 0.5 to less than 55% by weight.

**14.** An adhesive sheet as claimed in any of Claims 11 to 13, wherein the degree of swelling of the gel is 25 to 80 times.

**15.** An adhesive sheet as claimed in any preceding claim, wherein said 180° peeling adhesive force before irradiation is 2 to 17.7 N (200 to 1,8000 g/20 mm), and preferably 2 to 9.8 N (200 to 1,000 g/20 mm).

**Revendications**

**1.** Feuille adhésive mince utilisée dans le traitement de plaquettes de semi-conducteurs, comprenant un support perméable à la lumière et recouvert d'une couche adhésive sensible à la pression, qui peut être traitée par irradiation à l'aide de lumière pour former une structure en réseau tridimensionnelle, dans laquelle la couche adhésive sensible à la pression est une composition comportant 100 parties en poids d'un caoutchouc ou d'un polymère acrylique, de 1 à 100 parties en poids d'un composé photopolymérisable ayant une masse moléculaire moyenne en nombre de 10.000 ou moins et contenant au moins deux doubles liaisons carbone-carbone photopolymérisables dans la molécule et de 0,1 à 5 parties en poids d'un initiateur de photopolymérisation, et dans laquelle la force d'adhérence à un arrachement à 180°, de la couche adhésive sensible à la pression sur une plaquette de semi-conducteurs (déterminée pour une vitesse d'arrachement de 300 mm/min) sur une largeur unitaire de 20 mm est de 2N (200g/20mm) ou davantage et, après irradiation par la lumière, décroît jusqu'à 1,5 N (150g/20mm) ou moins.

**2.** Feuille adhésive telle que revendiquée dans la revendication 1, dans laquelle le support perméable à la lumière est une pellicule de plastique thermo-rétractable ou une résine synthétique extensible ou une pellicule de caoutchouc.

**3.** Feuille adhésive telle que revendiquée dans la revendication 2, dans laquelle le support est une pellicule de chlorure de polyvinyle, le téréphtalate de polyéthylène, le polyéthylène ou le polypropylène.

**4.** Feuille adhésive telle que revendiquée dans l'une quelconque des revendications précédentes, dans laquelle le support perméable à la lumière se présente sous une épaisseur pouvant aller de 10 à 300$\mu$m.

**5.** Feuille adhésive telle que revendiquée dans l'une quelconque des revendications précédentes, dans laquelle le polymère acrylique est un (méth)acrylate alkylique ou un copolymère comportant de 50 à 99,5% en poids d'un (méth)acrylate alkylique et de 50 à 0,5% en poids d'un monomère insaturé copolymérisable avec lui.

**6.** Feuille adhésive telle que revendiquée dans l'une quelconque des revendications précédentes, dans laquelle le composé photopolymérisable a une masse moléculaire moyenne en nombre de 5.000 ou moins.

7. Feuille adhésive telle que revendiquée dans l'une quelconque des revendications précédentes, dans laquelle le composé photopolymérisable a de 3 à 6 doubles liaisons carbonecarbone photopolymérisables dans sa molécule.

8. Feuille adhésive telle que revendiquée dans l'une quelconque des revendications précédentes, dans laquelle le composé photopolymérisable est choisi parmi le triacrylate de triméthylolpropane, le triacrylate de pentaérythritol, le tétraacrylate de pentaérithritol, le monohydroxypentaacrylate de dipentaérythritol et l'hexaacrylate de dipentaérythritol.

9. Feuille adhésive telle que revendiquée dans l'une quelconque des revendications précédentes, dans laquelle l'initiateur de photopolymérisation est choisi parmi l'éther benzoïne d'isopropyle, l'éther benzoïne d'isobutyle, la benzophénone, la cétone de Michler, la chlorothioxanthone, la dodécylthioxanthone, la diméthylthioxanthone, la diéthylthioxanthone, le diéthylcétal d'acétophénone, le diméthylcétal de benzyle, la $\alpha$-hydroxycyclohexyle phénylcétone et le 2-hydroxyméthylphénylpropane.

10. Feuille adhésive telle que revendiquée dans l'une quelconque des revendications précédentes, dans laquelle la couche adhésive sensible à la pression a une épaisseur qui peut être comprise entre 5 et 70 $\mu$m.

11. Feuille adhésive telle que revendiquée dans l'une quelconque des revendications précédentes, dans laquelle la couche adhésive sensible à la pression présente une résistance après élongation maximale de 100% à 20°C, de 10kg/cm$^2$ ou moins, a une teneur en gel (déterminée par immersion dans le toluène à 20°C pendant 24 heures) de moins de 55% en poids et un degré de gonflement du gel d'au moins 20 fois.

12. Feuille adhésive telle que revendiquée dans la revendication 11, dans laquelle l'élongation maximale de 100% se situe entre 0,5 et 8 kg/cm$^2$.

13. Feuille adhésive telle que revendiquée dans l'une des revendications 11 ou 12, dans laquelle la teneur en gel peut aller de 0,5 à moins de 55% en poids.

14. Feuille adhésive telle que revendiquée dans l'une quelconque des revendications 11 à 13, dans laquelle le degré de gonflement du gel est compris entre 25 et 80 fois.

15. Feuille adhésive telle que revendiquée dans l'une quelconque des revendications précédentes, dans laquelle ladite force d'adhérence à un arrachement à 180°, avant irradiation, est comprise entre 2 et 17,7 N (200 à 1.800g/20mm), et de préférence entre 2 et 9,8 N (200 à 1.000g/20mm).

## Patentansprüche

1. Dünne Klebefolie zur Verwendung bei der Bearbeitung von Halbleiterscheibchen, umfassend einen lichtdurchlässigen Träger und eine darauf vorgesehene druckempfindliche Klebeschicht, die durch Bestrahlung mit Licht unter Bildung einer dreidimensionalen Netzwerkstruktur gehärtet werden kann, wobei die druckempfindliche Klebeschicht eine Zusammensetzung ist, umfassend 100 Gewichtsteile eines Kautschuks oder Acrylpolymeren, 1 bis 100 Gewichtsteile einer photopolymerisierbaren Verbindung mit einem zahlenmittleren Molekulargewicht von 10 000 oder weniger, die wenigstens zwei photopolymerisierbare Kohlenstoff-Kohlenstoff-Doppelbindungenim Molekül enthält, und 0,1 bis 5 Gewichtsteile eines Photopolymerisationsinitiators, und wobei die 180°-Abschäl-Klebekraft der druckempfindlichen Klebeschicht gegenüber einem Halbleiterscheibchen (bestimmt bei einer Abschälgeschwindigkeit von 300 mm/min) auf einer Einheitsbreite von 20 mm 2 N (200 g/ 20 mm) oder mehr beträgt und nach der Bestrahlung mit Licht auf 1,5 N (150 g/ 20 mm) oder weniger abnimmt.

2. Klebefolie nach Anspruch 1, wobei der lichtdurchlässige Träger ein wärmeschrumpfbarer Kunststofffilm oder ein Film aus einem dehnbaren synthetischen Harz oder Kautschuk ist.

3. Klebefolie nach Anspruch 2, wobei der Träger ein Film aus Polyvinylchlorid, Polyethylenterephthalat, Polyethylen oder Polypropylen ist.

4. Klebefolie nach mindestens einem der vorangehende Ansprüche, wobei der lichtdurchlässige Träger eine Dicke von 10 bis 70 $\mu$m besitzt.

5. Klebefolie nach mindestens einem der vorangehenden Ansprüche, wobei das Acrylpolymer ein Alkyl-(meth)acrylat oder ein Copolymer, umfassend 50 bis 99,5 Gew.-% eines Alkyl(meth)acrylats und 50 bis 0,5 Gew.-% eines hiermit copolymerisierbaren ungesättigten Monomeren, ist.

6. Klebefolie nach mindestens einem der vorangehenden Ansprüche, wobei die photopolymerisierbare Verbindung ein zahlenmittleres Molekulargewicht von 5000 oder weniger besitzt.

7. Klebefolie nach mindestens einem der vorangehenden Ansprüche, wobei die photopolymerisierbare Verbindung 3 bis 6 photopolymerisierbare Kohlenstoff-Kohlenstoff-Doppelbindungen in ihrem Molekül besitzt.

8. Klebefolie nach mindestens einem der vorangehenden Ansprüche, wobei die photopolymerisierbare Verbindung aus Trimethylolpropantriacrylat, Pentaerythrittriacrylat, Pentaerythrittetraacrylat, Dipentaerythritmonohydroxypentaacrylat und Dipentaerythrithexaacrylat gewählt ist.

9. Klebefolie nach mindestens einem der vorangehenden Ansprüche, wobei der Photopolymerisationsinitiator aus Isopropylbenzoinether, Isobutylbenzoinether, Benzophenon, Michler's Keton, Chlorthioxanthon, Dodecylthioxanthon, Dimethylthioxanthon, Diethylthioxanthon, Acetophenon, Diethylketal, Benzyldimethylketal, $\alpha$-Hydroxycyclohexylphenylketon und 2-Hydroxymethylphenylpropan gewählt ist.

10. Klebefolie mindestens einem der vorangehenden Ansprüche, wobei die druckempfindliche Klebeschicht eine Dicke von 5 bis 70 $\mu$m besitzt.

11. Klebefolie nach mindestens einem der vorangehenden Ansprüche, wobei die druckempfindliche Klebeschicht eine Festigkeit nach dem 100 %-Modul bei 20° C von 10 kg/cm$^2$ oder weniger, einen Gelgehalt (bestimmt durch Eintauchen in Toluol bei 20° C über 24 h) von weniger als 55 Gew.-% und einen Quellungsgrad des Gels von mindestens 20-fach besitzt.

12. Klebefolie nach Anspruch 11, wobei der 100 %-Modul 0,5 bis 8 kg/cm$^2$ beträgt.

13. Klebefolie nach Anspruch 11 oder 12, wobei der Gelgehalt 0,5 bis weniger als 55 Gew.-% beträgt.

14. Klebefolie nach mindestens einem der Ansprüche 11 bis 13, wobei der Quellungsgrad des Gels 25- bis 80-fach ist.

15. Klebefolie nach mindestens einem der vorangehenden Ansprüche, wobei die 180°-Abschäl-Klebekraft vor der Bestrahlung 2 bis 17,7 N (200 bis 18000 g/20 mm) und vorzugsweise 2 bis 9,8 N (200 bis 1000 g/20 mm) beträgt.